# EUROPÄISCHE PATENTSCHRIFT

(11) **EP 0 810 445 B1**
(45) Veröffentlichungstag und Bekanntmachung des Hinweises auf die Patenterteilung: **22.01.2003**
(21) Anmeldenummer: 97107805.0
(22) Anmeldetag: 13.05.1997
(51) Int. Cl.: G01R 31/02

(54) **Verfahren zur Bestimmung der Schirmwirkung einer abgeschirmten Verkabelungsstrecke**
Method for the screen effectiveness determination of a part of a shielded cable
Procédé pour la détermination de l'efficacité du blindage d'une portion de cable blindé

(30) Priorität: 28.05.1996 DE 19621401
(43) Veröffentlichungstag der Anmeldung: 03.12.1997
(73) Patentinhaber: SIEMENS AKTIENGESELLSCHAFT, 80333 München (DE)
(72) Erfinder: Walter, Dieter, Dipl.-Ing. (FH), 85551 Kirchheim (DE)

(56) Entgegenhaltungen:
- WO-A-94/29737
- ELEKTRONIK, Bd. 45, Nr. 4, 20.Februar 1996, Seiten 96-99, XP000556043 MUND B: "KABEL AUF DEM EMV-PRUFSTAND"
- IBM TECHNICAL DISCLOSURE BULLETIN, Bd. 39, Nr. 5, 1.Mai 1996, Seiten 67-69, XP000584060 "CABLE SHIELDING EFFECTIVENESS SET UP"

## Beschreibung

Die Erfindung betrifft ein Verfahren zur Bestimmung der Schirmwirkung einer abgeschirmten, insbesondere fest installierten Verkabelungsstrecke.

Für die leitungsgebundene Übertragung von elektromagnetischen Signalen stehen in der heutigen Technik für die verschiedenen nutzbaren Frequenzbereiche unterschiedliche Leitungstypen zur Verfügung. In der Gleichstrom- und Niederfrequenztechnik werden vor allem Leitungen und Kabel mit ungeschirmten Kupferdrähten verwendet. Für die in der Nachrichten- und Hochfrequenztechnik genutzten Frequenzbereiche sind solche Kabel wegen der verstärkt auftretenden Hochfrequenzeffekte (Skineffekt, Störaussendung, hohe Dämpfung, Reflexionen usw.) jedoch nicht mehr als Übertragungsstrecken geeignet. Statt dessen kommen neben modernen Lichtwellenleitern (z.B. Glasfaserleitungen) vor allem abgeschirmte Kabel bzw. Hohlleiter (symmetrische Kabel und Koaxialkabel) zum Einsatz, bei denen ein Leitungsdraht - im folgenden als Innenleiter bezeichnet - von einer isolierenden Zwischenschicht oder einem Dielektrikum und von einer z.B. als Drahtgeflecht ausgebildeten Hülle aus leitfähigem Material umgeben ist. Ein in ein solches Kabel eingespeistes Signal breitet sich als elektromagnetische Welle im Zwischenraum von Innenleiter und Abschirmung aus, wobei die störenden Auswirkungen der genannten Hochfrequenzeffekte, insbesondere die Abstrahlung von Energie in den das Kabel umgebenden Raum, weitgehend vermieden werden.

In der Praxis werden derartige abgeschirmte Kabel z.B. im Rahmen einer informationstechnischen Kabelvernetzung in einem Gebände eingesetzt. Nach der Installation der Kabel sind meist Messungen des Betriebsverhaltens dieser Übertragungsstrecken entsprechend einschlägiger Normen (z.B. EN 50173), insbesondere in Bezug auf elektromagnetische Verträglichkeit (EMV), gefordert.

Außerhalb eines idealen koaxialen Schirms (oder bei mehradrigen Kabeln eines konzentrischen Schirms) treten keine elektromagnetischen Felder auf; eine reale Abschirmung weist jedoch ohmsche und induktive Widerstände auf, die zusammengefaßt als ihr *Kopplungswiderstand* bezeichnet werden. Die Qualität einer Abschirmung wird dabei in der Regel anhand ihres Kopplungswiderstandes bestimmt. Je niedriger der Kopplungswiderstand einer Abschirmung ausfällt, desto besser ist die damit erreichte Schirmwirkung. Die einzelnen Komponenten, wie Kabel und Steckverbindungen, einer Verkabelungsstrecke werden meist unter Anwendung definierter Meßmethoden gefertigt. Bei der Installation einer Verkabelungsstrecke können jedoch Fehler auftreten, indem z.B. Kabelschirme nicht sorgfältig mit Steckverbindungen verbunden oder Teile einer Abschirmung verletzt werden.

Die heute in der Praxis angewandten Methoden zur Überprüfung der Schirmqualität einer installierten und daher meist nur schlecht zugänglichen Verkabelungsstrecke beschränken sich in der Regel auf die Messung des Gleichstromwiderstandes der Abschirmung, wobei frequenzabhängige Effekte, wie z.B. die Verringerung der Schirmwirkung durch induktiv wirkende Schirmanschlüsse ("Pig Tails"), nicht erfaßt werden können. Daneben kommen auch sog. "Schnüffelsonden" zum Einsatz, mit denen nach aus der Abschirmung austretender Strahlung gesucht werden kann. Eine zuverlässige und quantitative Bestimmung der Schirmqualität ist damit jedoch nicht möglich.

Im "IBM Technical Disclosure Bulletin", Band 39, Nr. 5, "Cable Shielding Effectiveness Set Up", datiert vom 5.5.1996, ist ein Verfahren zur Messung der Schirmwirkung eines Kabels unter Laborbedingungen offenbart. Bei diesem Verfahren wird ein Hochfrequenzsender über ein erstes 4m langes Koaxialkabel an ein erstes Ende des zu vermessenden Kabels angeschlossen, dessen anderes Ende über ein zweites 4m langes Koaxialkabel mit einem vorgegebenen Abschlußwiderstand von 50 Ohm verbunden ist. Zur Messung der Schirmwirkung werden die sich über die Koaxialkabel fortpflanzender, durch Schirmungslecks des zu vermessenden Kabels verursachten Fehlströme gemessen. Zu diesem Zweck ist am ersten und am zweiten Koaxialkabel jeweils eine Stromwandlerzange angeordnet. Aufgrund des verhältnismäßig aufwendigen Meßaufbaus mit einem definierten Abschlußwiderstand eignet sich das bekannte Verfahren jedoch nicht zum Durchmessen real verlegter Verkabelungsstrecken. Das Meßergebnis würde insbesondere durch die an einem realen Verlegungsort vorliegenden Erdkreisimpedanzen verfälscht.

Die Aufgabe der Erfindung besteht daher darin, eine leicht realisierbare Methode anzugeben, mit der die Schirmqualität einer abgeschirmten, insbesondere fest installierten Verkabelungsstrecke zuverlässig und quantitativ bestimmt werden kann. Gelöst wird diese Aufgabe durch ein Verfahren, das die im Patentanspruch 1 angegebenen Merkmale aufweist.

Die Verkabelungsstrecke mit einem oder mehreren Innenleitern und einer Abschirmung wird dazu an einem ersten Ende mit wenigstens einem Innenleiter über ein Rangierkabel an einen ein elektrisches Signal aussendenden Sender angeschlossen, wobei ein Pol des Senderausgangs auf Massepotential gelegt und der andere Pol mit dem Rangierkabel leitend verbunden wird (Im folgenden werden die angeschlossenen Innenleiter gemeinsam als der Innenleiter" bezeichnet). Am zweiten Ende der Verkabelungsstrecke wird die Abschirmung auf Masse- oder Erdpotential gelegt und mit dem Innenleiter über einen Abschlußwiderstand leitend verbunden. Zur Bestimmung der Schirmwirkung wird die Abschirmung der Verkabelungsstrecke mit dem auf Masse- bzw- Erdpotential gelegten Pol des Senderausgangs durch eine am ersten Ende der Verkabelungsstrecke angeschlossene Rückleitung mit vorgegebener Impedanz verbunden, und mit Hilfe einer Meßvorrichtung wird die Differenzstromstärke, d.h. die Differenz der Beträge der Stromstärken, der durch das Rangierkabel und die Rückleitung fließenden Ströme in einen Meßwert umgesetzt. Aus dem vom Kopplungswiderstand der Abschirmung abhängigen Meßwert wird dann, z.B. durch Vergleich des Meßwerts mit einem theoretisch gewonnenen Bezugswert für eine entsprechende Verkabelungsstrecke mit unterbrochener Abschirmung, ein Wert für die Schirmwirkung der Verkabelungsstrecke bestimmt. Die bekannte Impedanz der Rückleitung weist dabei unter den gegebenen Meßbedingungen (d.h. bei dem in der Messung verwendeten Frequenzbereich) gegenüber dem Kopplungswiderstand der Abschirmung der Verkabelungsstrecke entweder einen ausreichend niedrigen Wert auf, um eine Verfälschung der Meßergebnisse zu vermeiden, oder sie wird bei der Bestimmung der Schirmwirkung aus dem Meßwert entsprechend berücksichtigt.

Zusätzlich ist zum ersten Meßvorgang ein zweiter Meßvorgang vorgesehen, bei dem die Verbindung der Abschirmung der Verkabelungsstrecke mit dem auf Massepotential gelegten Pol des Senderausgangs durch eine Rückleitung entfällt, und mit Hilfe der Meßvorrichtung die Stromstärke im Rangierkabel in einen zweiten Meßwert umgesetzt wird. Durch die Verknüpfung der Meßwerte für die beiden Meßvorgänge wird dann ein Wert für die Schirmwirkung der Verkabelungsstrecke bestimmt. Der zweite Meßwert dient dabei als Bezugsgröße, zu der der Meßwert aus dem ersten Meßvorgang ins Verhältnis gesetzt wird. Dieses Verhältnis stellt dann ein Maß für die Schirmwirkung der Verkabelungsstrecke dar.

Das erfindungsgemäße Verfahren ermöglicht eine einfache, zuverlässige, schnelle und quantitative Messung der Schirmwirkung bei einer abgeschirmten Verkabelungsstrecke. Es kann zudem auch dann ohne Einschränkung angewendet werden, wenn z.B. bei einer fest installierten Gebäudeverkabelung nur die beiden Enden der Verkabelungsstrecke frei zugänglich sind. Die vorgeschlagene Meßmethode erfordert dabei nur eine handelsübliche Meßausstattung und ist sowohl für Abnahmemessungen als auch bei der Fehlersuche geeignet.

Vorteilhafte Aus- und Weiterbildungen des erfindungsgemäßen Verfahrens sind Gegenstand der Unteransprüche.

Für den ersten Meßvorgang wird nach einer Ausgestaltung - Anspruch 2 - des erfindungsgemäßen Verfahrens ein Rangierkabel verwendet, das eine Abschirmung aufweist, die als Rückleitung dient. Damit erübrigt sich ein separates Kabel für die Rückleitung.

Bei einer zweiten Ausgestaltung der Erfindung - Anspruch 3 - werden mit Hilfe eines Senders variabler Frequenz bei unterschiedlichen Signalfrequenzen empirische Werte für die Schirmwirkung der abgeschirmten Verkabelungsstrecke ermittelt, um ihre Frequenzabhängigkeit zu bestimmen. Damit lassen sich beispielsweise Fehlerquellen finden, die nur in der Umgebung bestimmter Frequenzen, z.B. in Form von Resonanzen, auftreten.

Insbesondere, wenn an den Enden der Verkabelungsstrecke, wie z.B. bei Gebäudeverkabelungen meist der Fall, Steckdosen angeschlossen sind, ist es gemäß einer weiteren Ausgestaltung der Erfindung - Anspruch 4 - zweckmäßig, daß der Abscblußwiderstand als dazu passender Stecker ausgebildet ist.

Ein vorteilhafter Meßaufbau ergibt sich, wenn nach einer weiteren Ausführungsform des erfindungsgemäßen Verfahrens - Anspruch 5 - die Messung der Differenz der Stromstärken in dem Rangierkabel bzw. der Rückleitung induktiv erfolgt. Dabei erübrigt sich ein Einbringen von Meßgeräten in den Meßkreis. Eine induktive Messung ist dabei vor allem bei der Verwendung von hochfrequenten Prüfsignalen zweckmäßig.

Besonders zweckmäßig ist dabei die Verwendung einer Stromwandlerzange - Anspruche 6 - für die induktive Messung der Stromstärken. Beim ersten Meßvorgang wird die Stromwandlerzange dabei günstigerweise so um das Rangierkabel und die Rückleitung gelegt, daß die beiden zugehörigen Ströme in zueinander entgegengesetzter Richtung durch die Stromwandlerzange fließen, wodurch automatisch die gewünschte Differenzstromstärke in einen Meßwert umgesetzt wird.

Nachstehend wird die Erfindung anhand eines vorteilhaften Ausführungsbeispiels unter Bezugnahme auf die Zeichnungen näher erläutert.

Es zeigt
- FIG 1: einen vorteilhaften Meßaufbau für den ersten Meßvorgang;
- FIG 2: den entsprechenden Meßaufbau für den zweiten Meßvorgang.
In den Figuren ist ein Meßaufbau zur Bestimmung der Schirmwirkung einer abgeschirmten Verkabelungsstrecke KS mit einem Innenleiter L und einer Abschirmung AS dargestellt.

Die Verkabelungsstrecke KS wird dazu an einem ersten Ende E₁ mit ihrem Innenleiter L über ein Rangierkabel RK an einen ein elektrisches Hochfrequenz-Prüfsignal aussendenden Sender S angeschlossen, wobei ein Pol P₂ des Senderausgangs auf Masse - oder Erdpotential gelegt und der andere Pol P₁ mit dem Rangierkabel RK leitend verbunden wird. Am zweiten Ende E₂ der Verkabelungsstrecke KS, das an eine Steckdose angeschlossen ist, wird die Abschirmung AS auf Massepotential gelegt und mit dem Innenleiter L über einen Abschlußwiderstand RA, der als zur Steckdose passender Stecker ausgebildet ist, leitend verbunden. Der die Qualität der Abschirmung AS bestimmende Kopplungswiderstand ZK setzt sich aus ohmschen, kapazitiven und induktiven Komponenten zusammen.

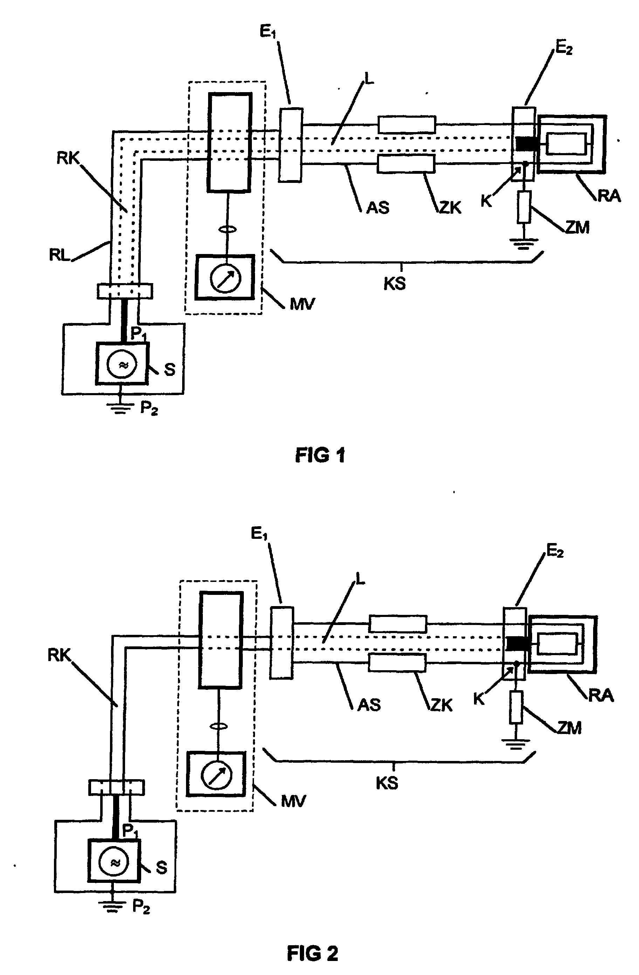

Zur Bestimmung der Schirmwirkung wird ein Meßaufbau nach FIG 1 und FIG 2 verwendet. Als Rangierkabel RK wird dabei eine abgeschirmte Leitung verwendet, deren Schirm als Rückleitung RL dient, mit der die Abschirmung AS der Verkabelungsstrecke KS von deren erstem Ende E₁ aus mit dem auf Massepotential gelegten Pol P₂ des Senderausgangs verbunden wird. Das vom Sender S ausgesandte Prüfsignal läuft über den Innenleiter des abgeschirmten Rangierkabels RK und weiter über den Innenleiter L der Verkabelungsstrecke KS. Über den Abschlußwiderstand RA gelangt das Signal am zweiten Ende der Verkabelungsstrecke KS zum Punkt K, an dem die Abschirmung AS an Masse- oder Erdpotential gelegt ist.
Die Impedanz ZM dieser Masseverbindung stellt einen ersten Zweig und der Kopplungswiderstand ZK der Abschirmung AS zusammen mit dem Widerstand der Rückleitung RL einen zweiten Zweig eines Spannungsteilers dar, über den das Prüfsignal vom Punkt K aus weiterläuft. Die Masseverbindung weist dabei einen Impedanzwert ZM auf, der in der Regel den Wert der im wesentlichen durch den Kopplungswiderstand ZK der Verkabelungsstrecke KS bestimmten Impedanz des anderen, zum zweiten Pol P₂ des Senderausganges zurückführenden Zweiges deutlich übersteigt (z.B. einige 100Ω für die Masseverbindung gegenüber einigen mΩ für den Kopplungswiderstand). Ist der Kopplungswiderstand ZK gegenüber der Impedanz ZM der Masseverbindung vernachlässigbar klein, so fließt der Signalstrom vom Punkt K aus fast vollständig über die Abschirmung AS und die Rückleitung RL und der Reststrom über Masse bzw. Erde zum Sender S zurück. Falls sich jedoch, z.B. durch eine Verletzung der Abschirmung AS, ein erhöhter Kopplungswiderstand ZK ergibt, fließt ein entsprechend höherer Teil des Signalstroms über die Masseleitung ab.
Mit Hilfe einer um das abgeschirmte Rangierkabel gelegten Stromwandlerzange als Meßvorrichtung MV wird die Differenzstromstärke, d.h. die Differenz der Beträge der Stromstärken, der durch das Rangierkabel und die Rückleitung fließenden Ströme in einen Meßwert umgesetzt. Aus diesem vom Kopplungswiderstand ZK der Abschirmung AS abhängigen Meßwert kann dann ein empirischer Wert für die Schirmwirkung der Verkabelungsstrecke KS bestimmt werden.

Zusätzlich zum ersten Meßvorgang ist ein zweiter Meßvorgang mit einem Meßaufbau nach FIG 2 vorgesehen. Dabei entfällt die Verbindung der Abschirmung AS der Verkabelungsstrecke KS mit dem auf Massepotential gelegten Pol P₂ des Senderausgangs durch eine Rückleitung RL. Als Rangierkabel RK wird entsprechend eine Leitung ohne Abschirmung verwendet. Durch den Wegfall der Rückleitung RL bedingt, fließt der gesamte Signalstrom vom Punkt K aus über die Masseverbindung ab. Dies entspricht dem praktischen Fall einer Schirmunterbrechung. Mit Hilfe der um das Rangierkabel RK gelegten Stromwandlerzange wird die Stromstärke im Rangierkabel RK in einen zweiten Meßwert umgesetzt. Durch die Verknüpfung der Meßwerte für die beiden mit derselben Signalfrequenz durchgeführten Meßvorgänge wird dann ein Wert für die Schirmwirkung der Verkabelungsstrecke bestimmt. Der zweite Meßwert dient dabei als Bezugsgröße, zu der der Meßwert aus dem ersten Meßvorgang ins Verhältnis gesetzt wird, wobei dieses Verhältnis ein Maß für die zu ermittelnde Schirmwirkung der Verkabelungsstrecke darstellt.

## Patentansprüche

1. Verfahren zur Bestimmung der Schirmwirkung einer abgeschirmten, insbesondere fest installierten, Verkabelungsstrecke (KS) mit Innenleiter (L) und Abschirmung (AS), wobei die Verkabelungsstrecke (KS) an einem ersten Ende (E₁) mit ihrem Innenleiter (L) über ein Rangierkabel (RK) an einen ein elektrisches Signal aussendenden Sender (S) angeschlossen wird, indem ein Pol (P₂) eines Senderausgangs auf Masse- oder Erdpotential gelegt und der andere Pol (P₁) mit dem Rangierkabel (RK) leitend verbunden wird, und direkt am zweiten Ende (E₂) der Verkabelungsstrecke (KS) die Abschirmung (AS) auf Masse-bzw. Erdpotential gelegt und mit dem Innenleiter (L) über einen Abschlußwiderstand (RA) leitend verbunden wird, wobei die Masseverbindung eine Impedanz (ZM) aufweist, und für die Bestimmung der Schirmwirkung ein Meßvorgang vorgesehen ist,
- wobei die Abschirmung (AS) der Verkabelungsstrecke (KS) mit dem auf Massepotential gelegten Pol (P₂) des Senderausgangs durch eine am ersten Ende (E₁) der Verkabelungsstrecke (KS) angeschlossene Rückleitung (RL) mit vorgegebener Impedanz verbunden wird; und
- mit Hilfe einer Meßvorrichtung (MV) die Differenzstromstärke der durch das Rangierkabel (RK) und die Rückleitung (RL) fließenden Ströme in einen Meßwert umgesetzt wird; und wobei ein zweiter Meßvorgang vorgesehen ist, bei dem
- die Verbindung der Abschirmung (AS) der Verkabelungsstrecke (KS) mit dem auf Massepotential gelegten Pol (P₂) des Senderausgangs durch eine Rückleitung (RL) entfällt; und
- mit Hilfe der Meßvorrichtung (MV) die Stromstärke im Rangierkabel (RK) in einen zweiten Meßwert umgesetzt wird; und
- aus dem Verhältnis der Meßwerte für die beiden Meßvorgänge ein Wert für die Schirmwirkung der Verkabelungsstrecke (KS) bestimmt wird.

2. Verfahren nach Anspruch 1,
**dadurch gekennzeichnet,**
**daß** für den ersten Meßvorgang eine Abschirmung des Rangierkabels (RK) als Rückleitung (RL) verwendet wird.

3. Verfahren nach einem der vorhergehenden Ansprüche,
**dadurch gekennzeichnet,**
**daß** mit Hilfe eines Senders (S) variabler Frequenz Werte für die Schirmwirkung bei unterschiedlichen Signalfrequenzen ermittelt werden.

4. Verfahren nach einem der vorhergehenden Ansprüche,
**dadurch gekennzeichnet,**
**daß** die Abschirmung (AS) mit dem Innenleiter (L) über einen steckbaren Abschlußwiderstand (RA) leitend verbunden wird.

5. Verfahren nach einem der vorhergehenden Ansprüche,
**dadurch gekennzeichnet,**
**daß** die Messung der Differenzstromstärke in dem Rangierkabel (RK) und der Rückleitung (RL) mit Hilfe der Meßvorrichtung (MV) induktiv erfolgt.

6. Verfahren nach Anspruch 5,
**dadurch gekennzeichnet,**
**daß** als Meßvorrichtung (MV) eine Stromwandlerzange verwendet wird.

## Claims

1. Method for determining the screening effect of a screened wiring section (KS), in particular a permanently installed wiring section, having an inner conductor: (L) and having a screen (AS), with the wiring section (KS) being connected at a first end (E₁) by means of its inner conductor (L) via a jumpering cable (RK) to a transmitter (S) which transmits an electrical signal, in that one pole (P₂) of a transmitter output is connected to a ground or earth potential, and the other pole (P₁) is conductively connected to the jumpering cable (RK), and the screen (AS) is connected to ground or earth potential directly at the second end (E₂) of the wiring section (KS) and is conductively connected to the inner conductor (L) via a terminating resistance (RA), with the ground connection having an impedance (ZM) and a measurement process being provided for determining the screening effect,
- with the screen (AS) of the wiring section (KS) being connected to that pole (P₂) of the transmitter output which is connected to ground potential by means of a return line (RL), which is connected to the first end (E₁) of the wiring section (KS) and has a predetermined impedance; and
- the differential current between the currents flowing through the jumpering cable (RK) and the return line (RL) being converted by means of a measurement apparatus (MV) to a measured value;
and with a second measurement process being provided, in which
- the connection of the screen (AS) of the wiring section (KS) to that pole (P₂) of the transmitter output which is connected to ground potential, by means of a return line (RL), is omitted; and
- the current in the jumpering cable (RK) is converted by means of the measurement apparatus (MV) to a second measured value; and
- a value for the screening effect of the wiring section (KS) is determined from the ratio of the measured values for the two measurement processes.

2. Method according to Claim 1,
**characterized**
**in that** a screen of the jumpering cable (RK) is used as the return line (RL) for the first measurement process.

3. Method according to one of the preceding claims,
**characterized**
**in that** values for the screening effect are determined at different signal frequencies, by means of a variable frequency transmitter (S).

4. Method according to one of the preceding claims,
**characterized**
**in that** the screen (AS) is conductively connected to the inner conductor (L) via a plug-in terminating resistance (RA).

5. Method according to one of the preceding claims,
**characterized**
**in that** the differential current in the jumpering cable (RK) and the return line (RL) is measured inductively by means of the measurement apparatus (MV).

6. Method according to Claim 5,
**characterized**
**in that** a current transformer adapter is used as the measurement apparatus (MV).

## Revendications

1. Procédé destiné à la détermination de l'efficacité du blindage d'une section (KS) de câbles blindés, notamment d'une section de câbles blindés installés à demeure, ayant un conducteur intérieur (L) et un blindage (AS), la section de câbles (KS) étant raccordée, à une première extrémité (E₁) par son conducteur intérieur (L), via un câble de connexion (RK), à un émetteur (S), qui émet un signal électrique, dans lequel une borne (P₂) d'une sortie de l'émetteur est mise au potentiel de la masse ou de la terre et l'autre borne (P₁) est reliée au câble de connexion (RK) et, directement à la deuxième extrémité (E₂) de la section de câbles (KS), le blindage (AS) est mis au potentiel de la masse ou de la terre et relié au conducteur intérieur (L) à travers une résistance de terminaison (RA), la connexion à la masse ayant une impédance (ZM) et dans lequel un processus de mesure est prévu pour la détermination de l'efficacité du blindage,
- le blindage (AS) de la section de câbles (KS) étant relié à la borne (P₂) de la sortie de l'émetteur, qui a été mise au potentiel de la masse, par un conducteur de retour (RL), d'une impédance donnée, raccordé à la première extrémité (E₁) de la section de câbles (KS); et
- à l'aide d'un dispositif de mesure (MV), la différence entre les intensités des courants qui circulent à travers le câble de connexion (RK) et le conducteur de retour (RL) étant convertie en une valeur de mesure;
et un deuxième processus de mesure étant prévu dans lequel
- la connexion entre le blindage (AS) de la section de câbles (KS) et la borne (P₂) de la sortie de l'émetteur, qui a été mise au potentiel de la masse, par un conducteur de retour (RL), est supprimée; et
- à l'aide du dispositif de mesure (MV), l'intensité du courant dans le câble de connexion (RK) est convertie en une deuxième valeur de mesure; et
- à partir du rapport entre les valeurs de mesure pour les deux processus de mesure, une valeur est déterminée pour l'efficacité du blindage de la section de câbles (KS).

2. Procédé selon la revendication 1
**caractérisé par le fait**
**que**, pour le premier processus de mesure, on utilise le blindage du câble de connexion (RK) en tant que conducteur de retour (RL).

3. Procédé selon l'une des revendications précédentes
**caractérisé par le fait**
**que**, à l'aide d'un émetteur (S) à fréquence variable, on détermine des valeurs pour l'efficacité du blindage à des fréquences de signal différentes.

4. Procédé selon l'une des revendications précédentes
**caractérisé par le fait**
**que** l'écran (AS) est relié au conducteur intérieur (L) à travers une résistance de terminaison (RA) enfichable.

5. Procédé selon l'une des revendications précédentes
**caractérisé par le fait**
**que** la mesure de la différence entre les intensités des courants dans le câble de connexion (RK) et le conducteur de retour (RL) est effectuée d'une manière inductive à l'aide du dispositif de mesure (MV).

6. Procédé selon la revendication 5
**caractérisé par le fait**
**qu'**on utilise une pince à transformateur de courant comme dispositif de mesure (MV).
